# Europäisches Patentamt

# European Patent Office

# Office européen des brevets

(11) Veröffentlichungsnummer: **0 141 434**
**B1**

(12) **EUROPÄISCHE PATENTSCHRIFT**

(45) Veröffentlichungstag der Patentschrift:
**26.10.88**

(21) Anmeldenummer: **84201179.3**

(22) Anmeldetag: **15.08.84**

(51) Int. Cl.⁴: **G 03 F 1/00**

(54) Verfahren zum Nachbessern von optischen Belichtungsmasken.

(30) Priorität: **17.08.83 DE 3329662**

(43) Veröffentlichungstag der Anmeldung:
**15.05.85 Patentblatt 85/20**

(45) Bekanntmachung des Hinweises auf die Patenterteilung:
**26.10.88 Patentblatt 88/43**

(84) Benannte Vertragsstaaten:
**DE FR GB NL**

(56) Entgegenhaltungen:
**FR - A - 2 175 141**
**US - A - 4 200 668**
**US - A - 4 383 016**

(73) Patentinhaber: **Philips Patentverwaltung GmbH,
Wendenstrasse 35 Postfach 10 51 49,
D-2000 Hamburg 1 (DE)**

(84) Benannte Vertragsstaaten: **DE**

(73) Patentinhaber: **N.V. Philips' Gloeilampenfabrieken,
Groenewoudseweg 1, NL-5621 BA Eindhoven (NL)**

(84) Benannte Vertragsstaaten: **FR GB NL**

(72) Erfinder: **Tietje, Hans-Gerhard, Lindenallee 38,
D-2057 Reinbek 5 (DE)**

(74) Vertreter: **Nehmzow-David, Fritzi-Maria et al, Philips
Patentverwaltung GmbH
Wendenstrasse 35 Postfach 10 51 49,
D-2000 Hamburg 1 (DE)**

## Beschreibung

Verfahren zum Nachbessern von optischen, auf einem für die angewendete Belichtungsstrahlung transparenten Substrat eine für die angewendete Belichtungsstrahlung nicht transparente Maskenstruktur enthaltenden Belichtungsmasken, bei dem nachzubessernde Stellen der Belichtungsmasken mit für die angewendete Belichtungsstrahlung nicht transparentem Material abgedeckt werden.

Optische Belichtungsmasken werden z.B. bei der Herstellung von elektronischen Bauelementen wie Transistoren, Dioden oder integrierten Schaltungen benötigt. Bei diesen Bauelementen sind die Kenngrössen in hohem Mass durch die Anbringungsstellen und die Abmessungen von am Halbleiterkörper angebrachten Metallisierungen und in bestimmten Fällen durch im Halbleiterkörper angebrachte Muster von Zonen unterschiedlichen Leitfähigkeitstyps bedingt, die z.B. durch Diffusion unter Anwendung maskierender Schichten erhalten werden. Aus diesem Grund muss eine sehr grosse Genauigkeit beim Anbringen von Metallisierungen und Zonen gefordert werden. Die beim Anbringen der verlangten Muster anzuwendenden Masken müssen darüberhinaus auch eine solche Festigkeit haben, dass sie mehrmals verwendet werden können. Aus diesen Gründen ist die Herstellung optischer Masken jeder Form mit der zu diesem Zweck notwendigen Genauigkeit technisch kompliziert und verhältnismässig kostspielig.

In der Praxis hat sich gezeigt, dass die besten Resultate erzielt werden, wenn eine Maske möglichst flach ist. Dabei muss die Maskenstruktur abriebfest sein, damit eine Maske mehrfach benutzt werden kann und sie muss ausserdem exakte, scharfe Ränder haben, damit über sie ein deutlich definiertes Bild auf der strahlungsempfindlichen Lackschicht abgebildet wird.

Diese Eigenschaften haben insbesondere Masken mit einer Maskenstruktur in Form eines Dünnschichtmusters auf einem für die Belichtungsstrahlung transparenten Substrat. Diese Dünnschichtmuster werden mit den aus der Dünnschichttechnologie bekannten Techniken, z.B. durch Aufdampfen oder Aufbringen durch Kathodenzerstäubung, auf das Substrat aufgebracht.

Bei diesen Herstellungsverfahren kommt es jedoch vor, dass die Maskenstruktur infolge von Poren (sogenannte pinholes) stellenweise transparent für die Belichtungsstrahlung wird und damit den optischen Anforderungen nicht mehr genügt.

Da die Maskenherstellung aufwendig und damit kostspielig ist, hat die Praxis nach Wegen gesucht, solche fehlerhaften Masken nicht sofort als Ausschuss aussondern zu müssen, sondern sie durch Nachbessern fehlerhafter Stellen doch verwendbar zu halten.

Aus US-PS 4 200 668 ist ein Verfahren zum Nachbessern von optischen Belichtungsmasken mit einer Maskenstruktur aus z.B. Chrom durch stromlose Abscheidung von Nickel, Chrom oder Aluminium bekannt. Es hat sich nun in der Praxis gezeigt, dass auf diese Weise ausgebesserte Maskenstrukturen nicht ausreichend haft- und abriebfest sind.

Aus US-PS 4 383 016 ist es bekannt, Maskenstrukturen aus z.B. Chrom oder Eisenoxid durch stromlose Abscheidung von Nickel auszubessern. Auch hier wirkt sich in der Praxis die nicht ausreichende Haft- und Abriebfestigkeit der ausgebesserten Strukturen nachteilig aus.

Der Erfindung liegt die Aufgabe zugrunde, Dünnschicht-Maskenstrukturen so nachzubessern, dass beim möglichst geringem apparativem Aufwand Maskenstrukturen erhalten werden, bei denen die Ausbesserungsstellen eine verbesserte Haft- und Abriebfestigkeit aufweisen.

Diese Aufgabe wird erfindungsgemäss dadurch gelöst, dass die nachzubessernden Stellen der Belichtungsmaske unter Maskierung der nicht nachzubessernden Stellen durch stromlose Abscheidung von Silber aus autokatalytisch arbeitenden Bädern metallisiert werden.

Gerade bei den in der Praxis bevorzugt angewendeten Masken aus Chrom oder aus Eisenoxid ($Fe_2O_3$) ist es vorteilhaft, durch stromlose Abscheidung aus autokatalytisch wirkenden Bädern Silber an den nachzubessernden Stellen anzubringen, weil durch dieses Verfahren schon bei sehr geringer Schichtdicke für die Belichtungsstrahlung nicht transparente Stellen erzeugt werden können, die eine hohe Haft- und Abriebfestigkeit aufweisen. Der Erfindung liegt hierbei die Erkenntnis zugrunde, dass zum Ausbessern von Maskenstrukturen aus Nichtedelmetallen oder Nichtedelmetalloxiden gerade Edelmetalle ganz besonders geeignet sind.

Beim chemischen Anbringen von dünnen Metallschichten gilt es als besonders zweckmässig, um porenfreie, gut haftende Schichten zu erreichen, das Substrat auf dem abgeschieden werden soll, nicht nur chemisch vorzubehandeln, (zu sensibilisieren), um die für die chemische Metallabscheidung notwendigen Kristallisationskeime zu erzeugen, sondern die Abscheidungsfläche sollte auch mechanisch vorbehandelt (aufgerauht) werden, um eine wirksame Kristallisationshilfe für das weitere Verfahren zu schaffen. Der Erfindung liegt die Erkenntnis zugrunde, dass eine mechanische Vorbehandlung der Flächen, auf denen abgeschieden werden soll nicht erforderlich ist und trotzdem eine weitere porenfreie, diffusionsfeste, duktile und gut haftende, also abriebfeste, Beschichtung im Bereich der Nachbesserungsstellen erreicht werden kann.

Die mit der Erfindung erzielten Vorteile bestehen insbesondere darin, dass Maskenstrukturen mit sehr geringem technischem Aufwand nachgebessert werden können, wobei abriebfeste Maskenstrukturen gleichmässiger Schichtdicke mit sehr guten optischen Qualitäten erreicht werden können. Ein weiterer Vorteil des erfindungsgemässen Verfahrens besteht darin, dass nicht nur Poren, also fehlerhafte Stellen, abgedeckt werden können, sondern dass die Maskenstrukturen auch abgewandelt und ergänzt werden können.

Als Ausführungsbeispiel der Erfindung wird die Abscheidung von Silberschichten auf den abzudeckenden Bereichen einer Maskenstruktur aus Chrom oder Eisenoxid $Fe_2O_3$ beschrieben. Die Sensibilisierung der mit Silber zu beschichtenden Bereiche der $Fe_2O_3$- oder Cr-Maskenstruktur erfolgt in dem zu beschreibenden Ausführungsbeispiel mit einer Lösung von Zinnchlorür. Dies ist besonders vorteilhaft, weil Kristallisationskeime aus Zinn insbesondere gegenüber Glas- oder Quarzoberflächen (Glas oder Quarz haben sich bevorzugt als Maskensubstrat bewährt) gute Grenzflächeneigenschaften zeigen.

Es ist aber möglich, auch andere geeignete Sensibilisierungslösungen einzusetzen. Unterschiedliche Bäder sowohl für die Sensibilisierung von Substraten aus Glas, Quarz, Keramik, Porzellan, Harzen, Harzgemischen, Papier und ähnlichem mit und ohne Metallbelag wie auch stromlos Kupfer, Nickel, Kobalt, Silber, Gold, Zinn, Rhodium und Zink abscheidende Bäder sind dem Fachmann wohl bekannt.

Durchführung des erfindungsgemässen Verfahrens:

Als Substrat zur Durchführung des Verfahrens diente eine optische Belichtungsmaske in Form einer mit einer Maskenstruktur aus $Fe_2O_3$ versehenen Platte aus Glas. Die Belichtungsmaske wird zur Maskierung der nicht abzudeckenden Stellen zunächst mit einer etwa 1 µm dicken Fotolackschicht überzogen, in der auf bekannte Weise die zu versilbernden Stellen der Belichtungsmaske freigelegt werden.

Nachdem die freigelegten Stellen gut gespült wurden, wird auf sie eine Sensibilisierungslösung A der nachfolgenden Zusammensetzung aufgetropft und zwei bis drei Min einwirken lassen.

Lösung A:
1 $\pm$ 0,1 g $SnCl_2$ und 1 $\pm$ 0,1 g Citronensäure $C_6H_8O_7 \cdot H_2O$, gelöst in 50 ml $H_2O_{reinst}$.

Die so vorbehandelte Belichtungsmaske wird anschliessend gut gespült unbd durch Abschleudern der Restflüssigkeit getrocknet.

Anschliessend wird eine stromlose Silber abscheidende Lösung hergestellt. Hierzu werden die unten spezifizierten Lösungen B und C zu gleichen Teilen gut vermischt auf die mit Silber zu beschichtenden Stellen der Belichtungsmaske aufgetropft. Pro Minute werden etwa 0,01 µm Silber abgeschieden. Nach Erreichen der gewünschten Schichtdicke wird die Belichtungsmaske gut gespült und durch Schleudern getrocknet.

Lösung B:
5 g $\pm$ 0,01 g $AgNO_3$ p.a., gelöst in 75 ml $H_2O_{reinst}$.
Zu dieser Lösung werden tropfenweise 4 bis 6 ml $NH_3$ (25%) zugegeben, bis eine klare Lösung vorliegt.

Lösung C:
0,9 $\pm$ 0,05 g Kalium-Natriumtartrat + 1,1 $\pm$ 0,05 g $AgNO_3$, nacheinander gelöst in 500 ml siedendem $H_2O_{reinst}$.

## Patentansprüche

1. Verfahren zum Nachbessern von optischen, auf einem für die angewendete Belichtungsstrahlung transparenten Substrat eine für die angewendete Belichtungsstrahlung nicht transparente Maskenstruktur enthaltenden Belichtungsmasken, bei dem nachzubessernde Stellen der Belichtungsmasken mit für die angewendete Belichtungsstrahlung nicht transparentem Material abgedeckt werden, dadurch gekennzeichnet, dass die nachzubessernden Stellen der Belichtungsmasken unter Maskierung der nicht nachzubessernden Stellen durch stromlose Abscheidung von Silber aus autokatalytisch arbeitenden Bädern metallisiert werden.

2. Verfahren nach Anspruch 1, dadurch gekennzeichnet, dass als Material für die Maskenstruktur Eisenoxid $Fe_2O_3$ eingesetzt wird.

3. Verfahren nach Anspruch 1, dadurch gekennzeichnet, dass als Material für die Maskenstruktur Chrom Cr eingesetzt wird.

4. Verfahren nach mindestens einem der Ansprüche 1–3, dadurch gekennzeichnet, dass die nachzubessernden Stellen zunächst mit einer Lösung A, bestehend aus
1 $\pm$ 0,1 g $SnCl_2$ und 1 $\pm$ 0,1 g Citronensäure $C_6H_8O_7 \cdot H_2O$, gelöst in 50 ml $H_2O_{reinst}$ für die stromlose Metallabscheidung vorbehandelt und anschliessend vermittels eines stromlos Silber abscheidenden, aus gleichen Teilen der Lösung B und C bestehenden Bades der nachfolgend angegebenen Zusammensetzung metallisiert werden:

Lösung B:
5 $\pm$ 0,01 g $AgNO_3$ p.a., gelöst in 75 ml $H_2O_{reinst}$ und 4 bis 6 ml $NH_3$ (25%ig)

Lösung C:
0,9 $\pm$ 0,05 g Ka-Na-Tartrat und 1,1 $\pm$ 0,05 g $AgNO_3$, nacheinander gelöst in 500 ml $H_2O_{reinst}$ bei 100 °C.

## Claims

1. A method of correcting optical exposure masks comprising on a substrate transparent to the exposure radiation used a mask structure not transparent to the exposure radiation used, in which areas to be corrected of the exposure masks are covered with a material not transparent to the exposure radiation used, characterized in that the areas to be corrected of the exposure mask, whilst masking the areas not to be corrected, are metallized by electroless deposition of silver from baths acting autocatalytically.

2. A method as claimed in Claim 1, characterized in that as material for the mask structure ferric oxide ($Fe_2O_3$) is used.

3. A method as claimed in Claim 1, characterized in that as material for the mask structure chromium (Cr) is used.

4. A method as claimed in at least one of Claims 1 to 3, characterized in that the areas to be corrected are first pretreated with a solution A consisting of:

1 $\pm$ 0.1 g of $SnCl_2$ and 1 $\pm$ 0.1 g of citric acid ($C_6H_8O_7 \cdot H_2O$) dissolved in 50 ml of $H_2O$ of highest purity for the electroless metal deposition and are them metallized by means of a bath of the composition indicatd below depositing silver in an electroless manner and consisting of equal parts of the solutions B and C:

Solution B:

5 $\pm$ 0.01 g of $AgNO_3$ p.a., dissolved in 75 ml of $H_2O$ of highest purity and 4 to 6 ml of $NH_3$ (25%);

Solution C:

0.9 $\pm$ 0.05 g of K-Na-tartrate and 1.1 $\pm$ 0.05 g of $AgNO_3$, dissolved successively in 500 ml of $H_2O$ of highest purity at 100 °C.

**Revendications**

1. Procédé de retouche de photomasques formés sur un substrat transparent au rayonnement d'exposition utilisé et qui comportent une structure non transparente à ce rayonnement, suivant lequel des parties des photomasques devant être retouchées sont recouvertes d'un matériau non transparent au rayonnement d'éxposition utilisé, caractérisé en ce que les parties du photomasque devant être retouchées sont métallisées par dépôt sans courant d'argent à partir de bains à action autocatalytique après masquage des partie qui ne doivent pas être retouchées.

2. Procédé selon la revendication 1, caractérisé en ce que le matériau de la structure de photomasque est de l'oxyde ferrique $FE_2O_3$.

3. Procédé selon la revendication 1, caractérisé en ce que le matériau de la structure de photomasque est du chrome Cr.

4. Procédé selon au moins l'une des revendications 1 à 3, caractérisé en ce que, pour le dépôt sans courant de métal, les parties à retoucher sont d'abord soumises à un traitement préparatoire par une solution A constituée par 1 $\pm$ 0,1 g de $SnCl_2$ et 1 $\pm$ 0,1 g d'acide citrique $C_6H_8O_7 \cdot H_2O$ dissous dans 50 ml de $H_2O$ extra-pure et en ce que, ensuite, elles sont métallisées au moyen d'un bain déposant de l'argent sans courant et constitué par des parties égales de la solution B et C, bain qui a la composition suivante:

Solution B:

5 $\pm$ 0,01 g de $AgNO_3$ analytiquement pur dissous dans 75 ml de $H_2O$ extra-pure et 4 à 6 ml de $NH_3$ (à 25%)

Solution C:

0,9 $\pm$ 0,05 g de tartrate de potassium et de sodium et 1,1 $\pm$ 0,05 g de $AgNO_3$ successivement dissous dans 500 ml de $H_2O$ extra-pure à 100 °C.